# EUROPÄISCHE PATENTANMELDUNG

(11) **EP 3 340 363 A1**
(43) Veröffentlichungstag der Anmeldung: **27.06.2018**
(21) Anmeldenummer: 16205722.8
(22) Anmeldetag: 21.12.2016
(51) Int. Cl.: H01M 10/48, G01R 31/36

(54) **GESUNDHEITSZUSTANDSERKENNUNG VON AKKUS**

(71) Anmelder: HILTI Aktiengesellschaft, 9494 Schaan (LI)
(72) Erfinder: Lepiorz, Matthias, 91413 Neustadt/Aisch (DE); Mayer, Stefan, 85221 Dachau (DE)
(74) Vertreter: Hilti Aktiengesellschaft Corporate Intellectual Property

(57) **Zusammenfassung**

Verfahren zum Ermitteln eines Wertes für einen Gesundheitszustand eines Akkumulators mit wenigstens einer Speicherzelle zur Stromversorgung einer Werkzeugmaschine, wobei der Akkumulator wenigstens einen Sensor zum Erfassen wenigstens eines Parameters des Akkumulators und/oder der wenigstens einen Speicherzelle sowie ein Batteriemanagementsystem zur Überwachung und Steuerung des Akkumulators sowie der wenigstens einen Speicherzelle enthält. Das Verfahren enthält das Erfassen wenigstens eines Parameters des Akkumulators und/oder der wenigstens einen Speicherzelle durch den wenigstens einen Sensor, das Abgleichen des wenigstens einen erfassten Parameters mit einer in dem Batteriemanagementsystem hinterlegten Kennlinie, wobei die Kennlinie das Verhältnis zwischen den erfassbaren Parametern und Werten für den Gesundheitszustand des Akkumulators beschreibt und das Ausgeben eines Wertes für den Gesundheitszustand eines Akkumulators entsprechend dem Verhältnis zwischen den erfassbaren Parametern und Werten für den Gesundheitszustand des Akkumulators.

## Beschreibung

Die vorliegende Erfindung betrifft Verfahren zum Ermitteln eines Wertes für einen Gesundheitszustand eines Akkumulators mit wenigstens einer Speicherzelle zur Stromversorgung einer Werkzeugmaschine, wobei der Akkumulator wenigstens einen Sensor zum Erfassen wenigstens eines Parameters des Akkumulators und/oder der wenigstens einen Speicherzelle sowie ein Batteriemanagementsystem zur Überwachung und Steuerung des Akkumulators sowie der wenigstens einen Speicherzelle enthält.

Akkumulatoren (oder Akkus) enthalten eine Anzahl an einzelnen Speicherzellen (oder Zellen) zur Aufnahme bzw. Speicherung von elektrischer Energie. Akkus dienen dabei häufig als Energieversorgung für Werkzeugmaschinen, wie z.B. Bohrhämmer, Winkelschleifer oder dergleichen.

Der Gesundheitszustand (englisch: State-of-Health) ist bei der verlässlichen und dauerhaften Verwendung von Akkus von entscheidender Bedeutung. Bei dem State-of-Health handelt es sich um eine Merit-Zahl, die Aufschluss über die spezifische Leistungsgröße gibt, die die Arbeitsfähigkeit des Akkus beschreibt.

So beschreibt der State-of-Health die Kapazität des Akkus bzw. der einzelnen Speicherzellen des Akkus bezogen auf die Nennkapazität, bzw. den Innenwiderstand in Bezug auf den Anfangswiderstand des Akkus bzw. der einzelnen Speicherzellen des Akkus.

Als Richtlinie für das Ende der Nutzbarkeit eines Akkus gilt bei der Verwendung als Energiespeicher in einer Werkzeugmaschine für gewöhnlich eine Unterschreitung von 60% der Nennkapazität bzw. eine Überschreitung von 200% des Anfangsinnenwiderstands. Bei einer derartigen Unter- bzw. Überschreitung ist eine ausreichende Nutzbarkeit des Akkus bzw. der einzelnen Speicherzellen nicht mehr gewährleistet.

Die Alterung des Akkus bzw. der einzelnen Speicherzellen bedingt eine Reduzierung des State-of-Healths. Insbesondere bei den weit verbreiteten Lithium-Ionen-Akkus wird die Alterung durch eine Vielzahl unterschiedlicher chemischer, elektrochemischer und mechanischer Mechanismen hervorgerufen. Durch diese Reaktionen verlieren Lithium-Ionen-Akkus die Fähigkeit elektrische Energie zu speichern, die für den Stromfluss notwendig sind. Die Alterung wird von verschiedenen Faktoren beeinflusst, beispielsweise durch die Temperatur oder den Ladezustand des Akkus. Bei hoher Temperatur und einem nahezu vollständig geladenen Akku entwickelt sich die Alterung von Lithium-Ionen-Akkus besonders schnell. Neben der Temperatur sind auch noch eine Anzahl an weiteren Faktoren bzw. Parametern für die Reduzierung des State-of-Healths des Akkus bzw. der einzelnen Speicherzellen ursächlich.

Die genaue und verlässliche Bestimmung des State-of-Health von Akkus bzw. den einzelnen Speicherzellen ist jedoch häufig problematisch und umständlich.

Aufgabe der vorliegenden Erfindung ist es daher, ein Verfahren zum Ermitteln eines Wertes für einen Gesundheitszustand eines Akkumulators mit wenigstens einer Speicherzelle zur Stromversorgung einer Werkzeugmaschine bereitzustellen, mit dem das vorstehend beschriebene Problem gelöst und insbesondere die Verwendung von Akkus als Energiespeicher für Werkzeugmaschinen verlässlicher gestaltet werden kann.

Die Aufgabe wird gelöst durch den Gegenstand des unabhängigen Anspruchs 1. Vorteilhafte Ausführungsformen des erfindungsgemäßen Gegenstands sind in den abhängigen Ansprüchen enthalten.

Die Aufgabe wird gelöst durch das Bereitstellen eines Verfahrens zum Ermitteln eines Wertes für einen Gesundheitszustand eines Akkumulators mit wenigstens einer Speicherzelle zur Stromversorgung einer Werkzeugmaschine, wobei der Akkumulator wenigstens einen Sensor zum Erfassen wenigstens eines Parameters des Akkumulators und/oder der wenigstens einen Speicherzelle sowie ein Batteriemanagementsystem zur Überwachung und Steuerung des Akkumulators sowie der wenigstens einen Speicherzelle enthält.

Erfindungsgemäß enthält das Verfahren die folgenden Verfahrensschritte:
- Erfassen wenigstens eines Parameters des Akkumulators und/oder der wenigstens einen Speicherzelle durch den wenigstens einen Sensor;
- Abgleichen des wenigstens einen erfassten Parameters mit einer in dem Batteriemanagementsystem hinterlegten Kennlinie, wobei die Kennlinie das Verhältnis zwischen den erfassbaren Parametern und Werten für den Gesundheitszustand des Akkumulators beschreibt; und
- Ausgeben eines Wertes für den Gesundheitszustand eines Akkumulators entsprechend dem Verhältnis zwischen den erfassbaren Parametern und Werten für den Gesundheitszustand des Akkumulators.

Hierdurch kann aufgrund von Erfahrungswerten (in Form der in dem Batteriemanagementsystem hinterlegten Kennlinie) auf effektive Art und Weise die schleichende Verschlechterung bzw. die Reduktion des Gesundheitszustands des Akkus bzw. der Speicherzellen erkannt und angezeigt werden.

Gemäß einer vorteilhaften Ausführungsform der vorliegenden Erfindung kann vorgesehen sein, dass der wenigstens eine Parameter ein Druck des Akkumulators und/oder der wenigstens einen Speicherzelle ist, wobei es sich bei der wenigstens einen Speicherzelle um eine in dem Akkumulator mechanisch fest eingespannte Speicherzelle handelt. Der Anstieg des Drucks im Akku bzw. in den Speicherzellen wird als eindeutiger Nachweis der Reduktion des Gesundheitszustands des Akkus bzw. der Speicherzellen genutzt.

Entsprechend einer weiteren vorteilhaften Ausführungsform kann vorgesehen sein, dass der wenigstens eine Parameter ein Volumen des Akkumulators und/oder der wenigstens einen Speicherzelle ist. Durch die Messung bzw. das Erfassen des Volumenanstiegs in dem Akku bzw. in den Speicherzellen ist ein weiterer eindeutiger Nachweis der Reduktion des Gesundheitszustands des Akkus bzw. der Speicherzellen gegeben.

Gemäß einer vorteilhaften Ausführungsform der vorliegenden Erfindung kann vorgesehen sein, dass der wenigstens eine Parameter ein ohmscher Widerstand des Akkumulators und/oder der wenigstens einen Speicherzelle ist, wobei das Erfassen des ohmschen Widerstands an einer Anode und/oder Kathode einer jeden Speicherzelle folgt. Hierdurch ist ein weiterer verlässlicher Nachweis der Reduktion des Gesundheitszustands des Akkus bzw. der Speicherzellen gegeben.

Weitere Vorteile ergeben sich aus der folgenden Figurenbeschreibung. In den Figuren sind verschiedene Ausführungsbeispiele der vorliegenden Erfindung dargestellt. Die Figuren, die Beschreibung und die Ansprüche enthalten zahlreiche Merkmale in Kombination. Der Fachmann wird die Merkmale zweckmässigerweise auch einzeln betrachten und zu sinnvollen weiteren Kombinationen zusammenfassen.

Es zeigen:
- Fig. 1: eine schematische Darstellung einer Werkzeugmaschine in Form eines Akku-Schraubers mit einem angeschlossenen Akku;
- Fig. 2: eine perspektive Darstellung des Akkus mit angedeuteten Speicherzellen in Ausgestaltung von Pouch-Zellen;
- Fig. 3: eine perspektive Darstellung des Akkus mit angedeuteten Speicherzellen in zylindrischer Form mit Hartschalen; und
- Fig. 4: eine grafische Darstellung einer Kennlinie zur Beschreibung des Verhältnisses von dem State-of-Health zu dem Innendruck eines Akkus bzw. den einzelnen Speicherzellen des Akkus.

### Ausführungsbeispiele:

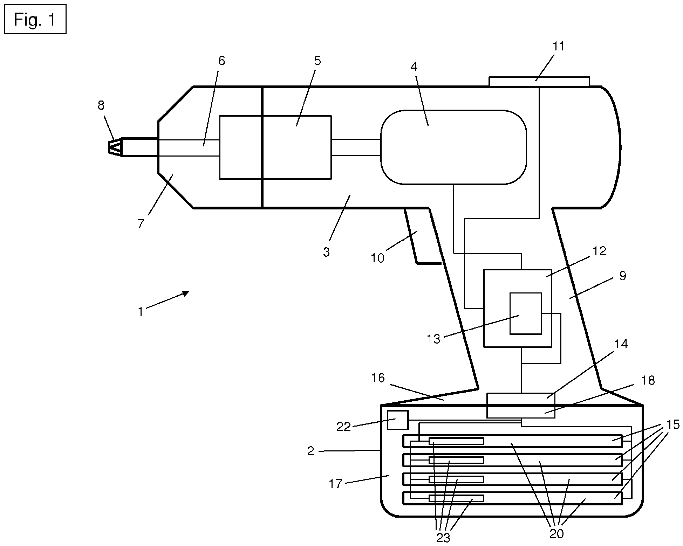

Figur 1 zeigt eine Werkzeugmaschine 1 mit einem Akkumulator 2 (auch Akku oder Primärzelle genannt) als Energieversorgung für die Werkzeugmaschine 1.

Die Werkzeugmaschine 1 ist in Ausgestaltung eines Akku-Schraubers ausgestaltet und enthält im Wesentlichen ein Hauptgehäuse 3, einen Elektromotor 4, ein Getriebe 5, eine Antriebswelle 6, eine Werkzeugaufnahme 7, ein Werkzeug 8, einen Handgriff 9 mit Bedienschalter 10, eine Anzeigenvorrichtung 11, eine Steuerung 12 mit einem Batteriemanagementsystem 13 und eine Schnittstelleneinrichtung 14 für den Akku 2. Es ist jedoch auch möglich, gemäß einer alternativen Ausgestaltungsform, dass die Werkzeugmaschine 1 in einer anderen Form eines Bohrhammers, Winkelschleifers, Kreissäge oder dergleichen ausgestaltet ist.

Wie der Fig. 1 zu entnehmen ist, sind in dem Hauptgehäuse 3 der Elektromotor 4, das Getriebe 5 und die Antriebswelle 6 positioniert. Ein in dem Elektromotor 4 erzeugtes Drehmoment wird über die Antriebswelle 6 und das Getriebe 5 an die Werkzeugaufnahme 7 übertragen. Die Werkzeugaufnahme 7 ist an dem vorderen Ende des Hauptgehäuses 3 positioniert, und dient zum Aufnehmen und Halten eines Werkzeugs 8 sowie zur Übertragung des im Elektromotor 4 erzeugten Drehmoments auf das Werkzeug 8. In dem vorliegenden Ausführungsbeispiel ist das Werkzeug 8 in Form eines Bits zum Drehen von Schrauben ausgestaltet. Schrauben sind in den Figuren nicht dargestellt.

Die Anzeigenvorrichtung 11 ist an einer Oberseite des Hauptgehäuses 3 positioniert und ist mit der Steuerung 12 sowie dem Batteriemanagementsystem 13 verbunden und dient unter anderem zum Anzeigen des Wertes für den Gesundheitszustand bzw. State-of-Health des Akkus 2. Der Akku enthält einzelne Speicherzellen 15 zum Speichern von elektrischer Energie.

Der Handgriff 9 ist an einem unteren Ende des Hauptgehäuses 3 befestigt und dient zum Halten sowie Führen der Werkzeugmaschine 1 durch einen Anwender. Im Inneren des Handgriffs 9 ist die Steuerung mit dem Batteriemanagementsystem 13 positioniert. Die Steuerung 12 und das Batteriemanagementsystem 13 sind miteinander verbunden. Die Steuerung 12 dient zur Überwachung und Steuerung der Werkzeugmaschine 1 und insbesondere der Drehzahl des Elektromotors 4. Das Batteriemanagementsystem 13 dient zur Überwachung und Steuerung des Akkus 2 und insbesondere der Funktionsweise der einzelnen Speicherzellen 15. Das Batteriemanagementsystem 13 ist hierzu über die Schnittstelleneinrichtung 14 mit dem Akku 2 sowie den einzelnen Speicherzellen 15 verbunden.

An einer vorderen Seite des Handgriffs 9 ist der Bedienschalter 10 angeordnet. Mit Hilfe des Bedienschalters 10 kann die als Akku-Schrauber ausgestaltete Werkzeugmaschine 1 aktiviert und die Drehzahl des Elektromotors 4 verändert werden. An dem unteren Ende des Handgriffs 9 ist ein Fußelement 16 vorgesehen, das eine Schnittstelleneinrichtung 14 für den Akku 2 enthält.

Die Schnittstelleneinrichtung 14 dient zum wiederlösbaren Verbinden des Akkus 2 mit dem Fußelement 16 der Werkzeugmaschine 1. Die Schnittstelleeinrichtung 14 stellt eine mechanische, elektrische und elektronische Verbindung zwischen der Werkzeugmaschine 1 und dem Akku 2 dar.

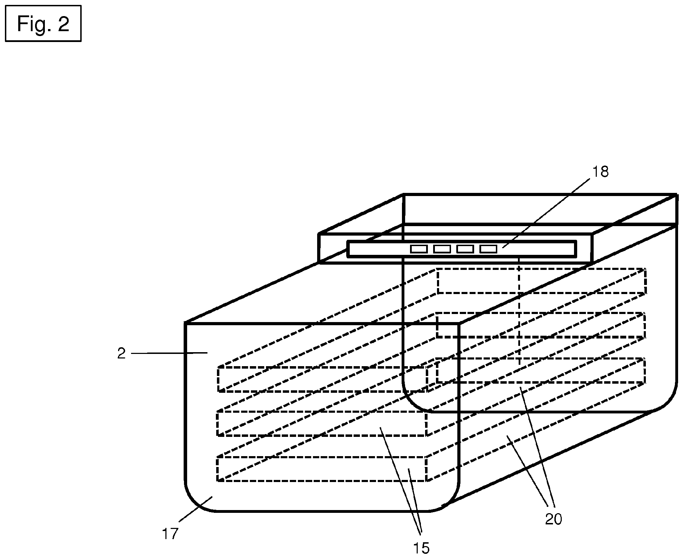

Bei dem Akku 2 handelt es sich um einen Lithium-Ionen-Akku bzw. einen Akku mit Lithium-Ionen-Speicherzellen. Der Akku 2 enthält im Wesentlichen ein Akkugehäuse 17, eine Schnittstelle 18 sowie die Speicherzellen 15. Bei den Speicherzellen 15 gemäß der Ausführungsform in Fig. 2 handelt es sich um sogenannte Pouch- oder Coffee-Bag-Zellen mit einer flexiblen Außenhülle 20 aus Aluminium.

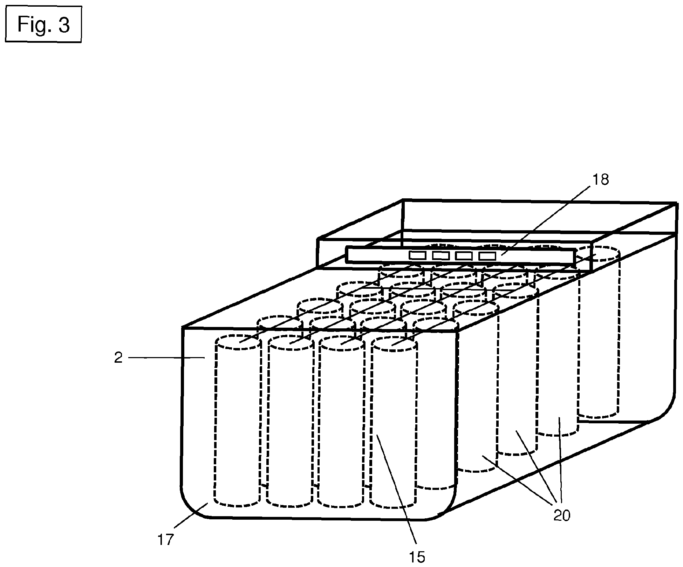

Bei den Speicherzellen 15 gemäß der alternativen Ausführungsform in Fig. 3 handelt es sich um Speicherzellen 15 in zylindrischer Form mit einer festen Außenhülle 21 (sog. hard-case Zellen).

Wie in Fig. 1 gezeigt, kann das Akkugehäuse 17 einen Sensor 22 in Form eines Volumenänderungssensors enthalten. Bei dem Volumenänderungssensor 22 kann es sich um einen Sensor mit Dehnungsmessstreifen, einen Taster oder einen Sensor mit einer optischen Messmethode (z.B. mit einem Laser) handeln. Der Volumenänderungssensor 22 dient zum Messen bzw. Erfassen einer Volumenänderung im Inneren des Akkugehäuses 17, d.h. insbesondere eines Anschwellens des gesamten Akkus 2 oder mindestens einer Speicherzelle 15 aufgrund einer Gasbildung innerhalb der Speicherzellen 15, welche infolge der Alterung der Akkus 2 bzw. der einzelnen Speicherzellen 15 entsteht.

In den einzelnen Speicherzellen 15 können jeweils ein Sensor 23 in Form eines Drucksensors und/oder eines Volumenänderungssensors enthalten sein. Bei den Drucksensoren kann es sich um Gasdrucksensoren handeln.

Darüber hinaus kann an beziehungsweise in jeder Speicherzelle 15 ein Sensor zur Messung des ohmschen Widerstands bzw. zur Messung einer Änderung des ohmschen Widerstands der Speicherzelle enthalten sein.

Die Verwendung der jeweiligen Sensoren 23 ist abhängig von der jeweiligen Bauweise des Akkus 2 bzw. der Anordnung und Befestigung der einzelnen Speicherzellen 15.

Bei der Verwendung eines Akkus 2, bei dem die einzelnen Speicherzellen 15 im Inneren des Akkugehäuses 17 mechanisch fixiert bzw. eingespannt sind, wird an den jeweiligen Speicherzellen 15 ein Drucksensor verwendet. Dadurch, dass die einzelnen Speicherzellen 15 in dem Akkugehäuse 17 fixiert sind, kann eine Volumenänderung in den Speicherzellen 15 durch den Sensor 22 an dem Akkugehäuse 17 nicht oder nicht in ausreichendem Maße erfasst werden. Anstelle dessen kann eine Druckänderung in den Speicherzellen 15 durch den entsprechenden Sensor 23 erfasst werden. Bei mechanisch fixierten Speicherzellen 15 wird der Innendruck in den jeweiligen Speicherzellen 15 durch einen Offset erhöht.

Bei der Verwendung eines Akkus 2, bei dem die einzelnen Speicherzellen 15 im Inneren des Akkugehäuses 17 lose und damit nicht mechanisch fixiert sind, wird an den jeweiligen Speicherzellen 15 ein Volumenänderungssensor verwendet. Dadurch, dass die einzelnen Speicherzellen 15 in dem Akkugehäuse 17 nicht fixiert sind, kann eine Volumenänderung in den Speicherzellen 15 durch den entsprechenden Sensor 23 erfasst werden.

Bei der Verwendung eines Akkus 2, bei dem die einzelnen Speicherzellen 15 im Inneren des Akkugehäuses 17 lose oder mechanisch fixiert sind, wird in den jeweiligen Speicherzellen 15 ein Drucksensor verwendet. Durch die Alterung der Speicherzellen 15 entsteht Gasbildung innerhalb derselben, wodurch der Druck ansteigt, welcher in den Speicherzellen 15 durch den entsprechenden Sensor 23 erfasst wird.

Die Messung des ohmschen Widerstands bzw. die Messung einer Änderung des ohmschen Widerstands der Speicherzelle 15 erfolgt über die Widerstandsmessung einer, bzw. beider Elektroden (d.h. Anode und Kathode) der Speicherzellen. Hierzu wird in den einzelnen Speicherzellen 15 eine Elektrodenwiderstandsmessung integriert, beispielsweise durch eine Referenzelektrode auf der Elektrodenoberfläche mit Messung des elektrischen Widerstands zwischen dem Stromableiter und der Referenzelektrode.

Die Sensoren 22, 23 sind über entsprechende Leitungen L sowie der Schnittstelle 18 und Schnittstelleneinrichtung 14 mit dem Batteriemanagementsystem 13 verbunden, können grundsätzlich aber auch Daten kontaktlos übertragen (beispielsweise über Funk, Bluetooth, etc.).

Durch die Alterung der Speicherzellen 15 verändern sich die Parameter bzw. Eigenschaften der Speicherzellen 15, insbesondere die Kapazität und der Innenwiderstand. Ein durch die Effekte der Alterung der Speicherzelle 15 verursachter Anstieg des Drucks im Inneren der Lithium-Ionen-Speicherzellen 15 führt zu einer Verringerung der Kapazität in Bezug auf die Nennkapazität und/oder zu einem Anstieg des Innenwiderstands im Verhältnis zu dem Anfangsinnenwiderstand.

Je nach Beschaffenheit und Bauart des Akkus 2 und der darin positionierten Speicherzellen 15 kann es neben der Druckänderung auch zu einem Volumenanstieg der Speicherzelle 15 kommen. Darüber hinaus kann es auch zu einem Anstieg des Innenwiderstands der Speicherzellen 15 kommen.

Die Alterung und speziell die Effekte der Alterung der Speicherzellen 15 können in Form des Gesundheitszustands bzw. State-of-Health ausgedrückt werden, sodass eine neue Speicherzelle 15 einen State-of-Health von 100% aufweist. Wenn ein Akku 2 bzw. die Speicherzellen 15 einen State-of-Health von weniger als 60% aufweisen, ist das Lebensende des Akkus 2 bzw. der jeweiligen Speicherzelle 15 durch die zu geringe Kapazität und den zu hohen Innenwiederstand erreicht.

In dem Batteriemanagementsystem 13 sind Kennlinien gespeichert, die zum Abgleich mit den durch die Sensoren 22, 23 erfassten Werten bzw. Parametern des Akkus 2 und/oder der Speicherzellen 15 dienen. Durch den Abgleich mit Hilfe der Kennlinien kann der aktuelle und durch vorschreitende Alterung veränderte Wert für den State-of-Health des Akkus 2 oder einer Speicherzelle 15 ermittelt werden.

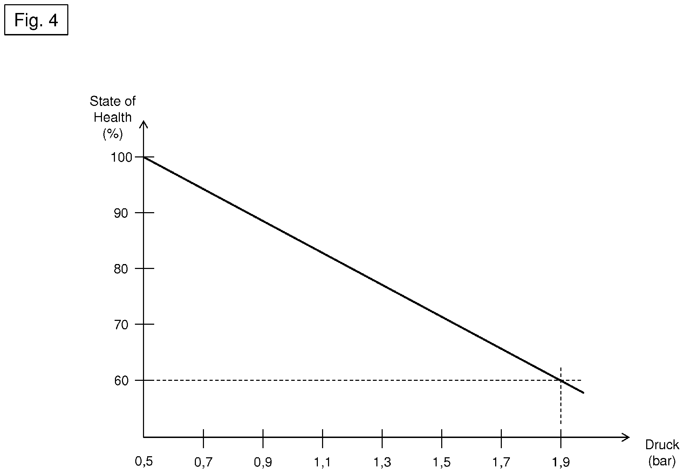

In Fig. 4 ist eine grafische Darstellung einer Kennlinie für das Verhältnis zwischen dem State-of-Health und dem Druck in einem Akku 2 oder einer Speicherzelle 15 gezeigt. Wie der Grafik zu entnehmen ist, wird der kritische State-of-Health-Wert von 60% bei einem Druck von 1,9 bar erreicht.

Für die Ermittlung des Wertes für den State-of-Health wird zunächst wenigstens ein Parameter, z.B. Druck, Volumen oder Innenwiderstand, des Akkus 2 und/oder von wenigstens einer Speicherzelle 15 durch den entsprechenden Sensor 22, 23 erfasst. Anschließend wird der erfasste Parameter mit der entsprechenden in dem Batteriemanagementsystem 13 hinterlegten Kennlinie abgeglichen, um den Wert für den State-of-Health entsprechend dem Verhältnis zu den erfassbaren Parametern auszugeben.

Der ermittelte Wert für den State-of-Health für den Akku 2 und/oder der Speicherzellen 15 wird optisch oder akustisch mit Hilfe der Anzeigenvorrichtung 11 angezeigt.

## Patentansprüche

1. Verfahren zum Ermitteln eines Wertes für einen Gesundheitszustand eines Akkumulators (1) mit wenigstens einer Speicherzelle (15) zur Stromversorgung einer Werkzeugmaschine (1), wobei der Akkumulator (2) wenigstens einen Sensor (22, 23) zum Erfassen wenigstens eines Parameters des Akkumulators (2) und/oder der wenigstens einen Speicherzelle (15) sowie ein Batteriemanagementsystem (13) zur Überwachung und Steuerung des Akkumulators (2) sowie der wenigstens einen Speicherzelle (15) enthält, **gekennzeichnet durch** die folgenden Verfahrensschritte:
- Erfassen wenigstens eines Parameters des Akkumulators (2) und/oder der wenigstens einen Speicherzelle (15) **durch** den wenigstens einen Sensor (22, 23);
- Abgleichen des wenigstens einen erfassten Parameters mit einer in dem Batteriemanagementsystem (13) hinterlegten Kennlinie, wobei die Kennlinie das Verhältnis zwischen den erfassbaren Parametern und Werten für den Gesundheitszustand des Akkumulators (2) beschreibt; und
- Ausgeben eines Wertes für den Gesundheitszustand eines Akkumulators (2) entsprechend dem Verhältnis zwischen den erfassbaren Parametern und Werten für den Gesundheitszustand des Akkumulators (2).

2. Verfahren nach Anspruch 1,
**dadurch gekennzeichnet, dass** der wenigstens eine Parameter ein Druck des Akkumulators (2) und/oder der wenigstens einen Speicherzelle (15) ist, wobei es sich bei der wenigstens einen Speicherzelle (15) um eine in dem Akkumulator (2) mechanisch fest eingespannte Speicherzelle (15) handelt.

3. Verfahren nach Anspruch 1,
**dadurch gekennzeichnet, dass** der wenigstens eine Parameter ein Volumen des Akkumulators (2) und/oder der wenigstens einen Speicherzelle (15) ist.

4. Verfahren nach Anspruch 1,
**dadurch gekennzeichnet, dass** der wenigstens eine Parameter ein ohmscher Widerstand des Akkumulators (2) und/oder der wenigstens einen Speicherzelle (15) ist, wobei das Erfassen des ohmschen Widerstands an einer Anode und/oder Kathode einer jeden Speicherzelle (15) folgt.
